(19) Europäisches Patentamt
European Patent Office
Office européen des brevets

(11) **EP 2 753 944 B1**

(12) **FASCICULE DE BREVET EUROPEEN**

(45) Date de publication et mention
de la délivrance du brevet:
**24.06.2015 Bulletin 2015/26**

(21) Numéro de dépôt: **12761931.0**

(22) Date de dépôt: **05.09.2012**

(51) Int Cl.:
**G01R 31/11** (2006.01)  **G01R 31/00** (2006.01)

(86) Numéro de dépôt international:
**PCT/EP2012/067253**

(87) Numéro de publication internationale:
**WO 2013/034565 (14.03.2013 Gazette 2013/11)**

(54) **SYSTEME ET PROCEDE DE REFLECTOMETRIE TEMPORELLE POUR LA LOCALISATION NON AMBIGUE D'UN DEFAUT ELECTRIQUE DANS UN CABLE**

ZEITLICHES REFLEKTOMETRIESYSTEM UND VERFAHREN ZUR EINDEUTIGEN ORTUNG EINES ELEKTRISCHEN DEFEKTS IN EINEM KABEL

TEMPORAL REFLECTOMETRY SYSTEM AND METHOD FOR UNAMBIGUOUSLY LOCATING AN ELECTRICAL DEFECT IN A CABLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.09.2011 FR 1158016**

(43) Date de publication de la demande:
**16.07.2014 Bulletin 2014/29**

(73) Titulaire: **Commissariat à l'Énergie Atomique et aux Énergies Alternatives
75015 Paris (FR)**

(72) Inventeur: **INCARBONE, Luca
F-75015 Paris (FR)**

(74) Mandataire: **Hammes, Pierre et al
Marks & Clerk France
Immeuble Visium
22, avenue Aristide Briand
94117 Arcueil Cedex (FR)**

(56) Documents cités:
WO-A2-03/027691     WO-A2-2004/072814
FR-A1- 2 946 149     GB-A- 2 463 689

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente invention concerne le domaine de la réflectométrie temporelle et a notamment pour but de localiser, de façon non ambigüe, un défaut dans un câble électrique.

L'invention s'applique à tout type de câble électrique, en particulier des câbles de transmission d'énergie, dans des installations fixes ou mobiles. Les câbles concernés peuvent être coaxiaux, bifilaires, en lignes parallèles, en paires torsadées ou autre.

L'invention s'applique avantageusement à des réseaux électriques complexes composés d'une pluralité de câbles interconnectés selon une structure ramifiée. Par exemple, l'invention peut être utilisée pour le diagnostic des réseaux de distribution de puissance dans un avion.

Les systèmes de réflectométrie temporelle connus fonctionnent classiquement selon le procédé suivant. Un signal maitrisé, par exemple un signal impulsionnel ou encore un signal multi-porteuses, est injecté à une extrémité du câble à tester. Le signal se propage le long du câble et se réfléchit sur les singularités qu'il comporte.

Une singularité dans un câble correspond à une rupture des conditions, de propagation du signal dans ce câble. Elle résulte le plus souvent d'un défaut qui modifie localement l'impédance caractéristique du câble en provoquant une discontinuité dans ses paramètres linéiques.

Le signal réfléchi est rétropropagé jusqu'au point d'injection, puis est analysé par le système de réflectométrie. Le retard entre le signal injecté et le signal réfléchi permet de localiser une singularité, correspondant à un défaut électrique, dans le câble.

Dans certains cas, il n'est cependant pas possible ou souhaitable d'injecter le signal de réflectométrie à une extrémité du câble. En particulier, dans un réseau électrique complexe et ramifié, l'extrémité du câble à tester n'est pas toujours accessible. En outre, pour des applications embarquées, par exemple dans un avion, l'implémentation du système de réflectométrie doit respecter des contraintes de compacité et le positionnement de ce système dans le réseau électrique à tester peut être imposé par le fabricant. Par exemple, lorsque des systèmes de protection, tels des disjoncteurs, sont présents dans le réseau électrique, il peut être avantageux de disposer le système de réflectométrie au même emplacement.

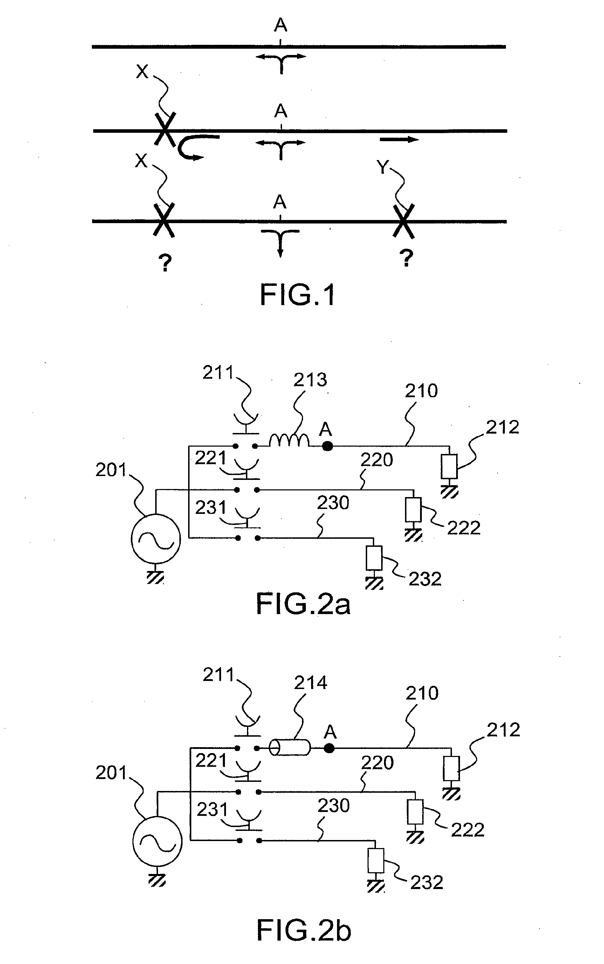

Ainsi, il existe de nombreuses applications pour lesquelles le signal de réflectométrie temporelle doit être injecté en un point quelconque du câble à tester et non pas seulement à son extrémité. Dans ce cas, la localisation du défaut ne pourra pas se faire de façon non ambigüe comme cela est illustré à la figure 1.

En effet, le signal injecté en un point A quelconque du câble se propage dans les deux directions opposées. Lorsqu'un défaut existe en un point X situé à gauche du point A, l'analyse du signal réfléchi sur ce défaut permet uniquement de déterminer la distance, en valeur absolue, entre le défaut et le point d'injection A mais ne permet pas de savoir si ce défaut est localisé à gauche (point X) ou à droite (point Y) du point d'injection.

En outre, lorsque des défauts électriques existent des deux cotés du point A d'injection, le signal réfléchi reçu au point A est constitué de la superposition des réflexions dans les deux directions opposées du câble. L'analyse effectuée s'en trouve alors dégradée.

Les solutions connues permettant de localiser de façon non ambigüe un défaut électrique sont basées sur l'insertion de composants supplémentaires sur la ligne électrique à tester de manière à filtrer le signal injecté.

Sur la figure 2a est représenté un réseau électrique à tester composé d'un générateur 201 relié à trois lignes électriques 210,220,230, chacune comportant un disjoncteur 211,221,231 et étant terminées par une charge 212,222,232. La ligne électrique à tester est la ligne 210 et le point d'injection du signal de réflectométrie est le point A.

Une première solution pour imposer une recherche de défauts uniquement entre le point d'injection A et la charge 212 consiste à introduire entre le point A et le disjoncteur 211 une bobine 213 qui permet d'interrompre la ligne en agissant comme un filtre passe-bas. Le signal injecté se propageant en direction du disjoncteur 211 est ainsi bloqué par la bobine 213 et n'est pas réfléchi. Ainsi, il est possible d'imposer le test d'un seul côté du câble à la fois.

Un inconvénient de cette première solution est son aspect intrusif. Elle nécessite l'introduction d'un composant supplémentaire dans le câble qui de plus peut présenter une dimension importante ce qui pose en outre un problème d'encombrement.

Une seconde solution, schématisée à la figure 2b, consiste à introduire, à la place de la bobine 213, un anneau ferromagnétique ou ferrite 214 pour réaliser de la même façon un filtre passe-bas.

Cependant cette solution, bien qu'ayant l'avantage d'être moins intrusive, présente toujours l'inconvénient de nécessiter l'introduction d'un composant supplémentaire et donc de proposer une solution plus couteuse et plus encombrante. En outre, cette solution ne permet pas un filtrage total de toutes les composantes fréquentielles du signal injecté.

On connait par ailleurs le système de réflectométrie décrit dans la demande de brevet publiée sous le numéro GB 2463689 A.

Un des buts de la présente invention est de proposer une solution permettant de localiser de façon non ambigüe un défaut électrique, à partir d'un accès à un point quelconque du câble. L'invention ne nécessite pas l'introduction de composants supplémentaires et est peu encombrante.

A cet effet, l'invention a pour objet un système de réflectométrie temporelle pour la localisation, non ambigüe, d'au moins une singularité dans un câble, caractérisé en ce qu'il comprend des moyens de calcul de signaux de réflectométrie adaptés à générer un premier signal d'injection $f_A(t)$ et un second signal d'injection $f_B(t)$ à partir d'au moins un signal de réflectométrie $s(t)$, et deux moyens de couplage et de transmission desdits signaux d'injection $f_A(t),f_B(t)$ en deux points distincts (A,B) dudit câble, lesdits signaux d'injection $f_A(t),f_B(t)$ étant construits de sorte que le signal se propageant d'un côté dudit câble est égal audit signal de réflectométrie $s(t)$ et le signal se propageant de l'autre côté dudit câble est sensiblement nul.

Selon un aspect particulier de l'invention, le premier signal d'injection $f_A(t)$ est déterminé par intégration temporelle du signal de réflectométrie $s(t)$.

Selon un aspect particulier de l'invention, ledit second signal d'injection $f_B(t)$ est égal à l'opposé dudit premier signal d'injection $f_A(t)$ et est injecté dans le câble avec un retard prédéterminé, par rapport à l'instant d'injection dudit premier signal d'injection $f_A(t)$.

Selon un aspect particulier de l'invention, ledit retard est égal à la distance entre lesdits points d'injection (A,B) divisée par la vitesse de propagation du signal dans le câble.

Selon un aspect particulier de l'invention, lesdits signaux d'injection $f_A(t),f_B(t)$ sont générés sous forme numérique $f_A(n),f_B(n)$, ledit système comportant en outre des moyens de conversion pour convertir lesdits signaux $f_A(n),f_B(n)$ numériques en signaux analogiques $f_A(t),f_B(t)$.

Selon un aspect particulier de l'invention, lesdits signaux numériques $f_A(n),f_B(n)$ sont construits par résolution du système d'équation suivant :

$$\begin{cases} f_A(n+k) + f_B(n) = 0 \\ f_B(n) + f_A(n-k) = s(n+k) \end{cases}$$

où $k$ est égal au rapport entre le temps de propagation $\Delta t_{AB}$ du signal entre les points A et B et la période d'échantillonnage $T_e$ desdits signaux numériques.

Selon un aspect particulier de l'invention, la distance entre les deux points d'injection (A,B) est égale à un multiple ou sous-multiple de la période d'échantillonnage $T_e$ desdits convertisseurs numérique-analogique que multiplie la vitesse de propagation du signal dans le câble.

Dans une variante de réalisation, le système de réflectométrie temporelle selon l'invention comporte en outre au moins un convertisseur analogique-numérique pour convertir le signal réfléchi sur ladite singularité et reçu par lesdits moyens de couplage et de transmission, lesdits moyens de calcul étant en outre adaptés à recevoir et analyser ledit signal réfléchi, converti numériquement, pour produire un réflectogramme temporel.

Selon un aspect particulier de l'invention, lesdits moyens de couplage et de transmission sont réalisés par effet capacitif, inductif ou par connexion ohmique.

Selon un aspect particulier de l'invention, lesdits moyens de couplage et de transmission sont des moyens sans contact.

Dans une variante de réalisation, le système de réflectométrie temporelle selon l'invention comprend en outre au moins un moyen de couplage d'un convertisseur analogique-numérique avec un convertisseur numérique-analogique.

Selon un aspect particulier de l'invention, lesdits moyens de couplage sont des coupleurs ou des diviseur-combineurs.

Selon un aspect particulier de l'invention, les moyens de calcul sont mis en oeuvre par un circuit à logique programmable ou un micro-contrôleur.

Dans une variante de réalisation, le système de réflectométrie temporelle selon l'invention comprend en outre une unité de traitement adaptée à piloter ledit système et à afficher les dits réflectogrammes sur une interface homme-machine.

L'invention a également pour objet un procédé de localisation non ambigüe d'au moins une singularité dans un câble caractérisé en ce qu'il comporte au moins les étapes suivantes :

- construire un premier signal d'injection $f_A(t)$ et un second signal d'injection $f_B(t)$ à partir d'un signal de réflectométrie $s(t)$ de sorte que le signal se propageant d'un côté dudit câble est égal audit signal de réflectométrie $s(t)$ et le signal se propageant de l'autre côté dudit câble est sensiblement nul,
- injecter lesdits signaux d'injection $f_A(t),f_B(t)$, en deux points distincts (A,B) dudit câble,
- acquérir le signal réfléchi sur au moins une singularité du câble,
- produire, à partir du signal réfléchi, au moins un réflectogramme temporel,
- déterminer, à partir dudit réflectogramme temporel, la position non ambigüe de la singularité sur le câble.

Selon un aspect particulier du procédé selon l'invention, ledit premier signal $f_A(t)$ est déterminé par intégration temporelle du signal de réflectométrie $s(t)$.

Selon un aspect particulier du procédé selon l'invention, ledit second signal d'injection $f_B(t)$ est égal à l'opposé dudit premier signal d'injection $f_A(t)$ et est injecté dans le câble avec un retard prédéterminé, par rapport à l'instant d'injection dudit premier signal d'injection $f_A(t)$.

Selon un aspect particulier du procédé selon l'invention, ledit retard est égal à la distance entre lesdits points d'injection (A,B) divisée par la vitesse de propagation du signal dans le câble.

Selon un aspect particulier du procédé selon l'invention, lesdits signaux $f_A(n),f_B(n)$ sont construits numériquement par résolution du système d'équation suivant :

$$\begin{cases} f_A(n+k) + f_B(n) = 0 \\ f_B(n) + f_A(n-k) = s(n+k) \end{cases}$$

où $k$ est égal au rapport entre le temps de propagation $\Delta t_{AB}$ du signal entre les points A et B et la période d'échantillonnage $T_e$ desdits signaux numériques.

Selon un aspect particulier du procédé selon l'invention, les points A et B sont séparés d'une distance égale à un multiple ou sous-multiple de la période d'échantillonnage $T_e$ des signaux numériques $f_A(n),f_B(n)$.

D'autres caractéristiques et avantages de l'invention apparaîtront à l'aide de la description qui suit faite en regard de dessins annexés qui représentent :

- la figure 1, un schéma illustrant le problème de localisation ambigüe d'un défaut électrique dans un câble à partir de l'injection d'un signal de réflectométrie en un point quelconque dudit câble,
- les figures 2a et 2b, deux schémas d'exemples de solution connues au problème susvisé,
- la figure 3, un premier schéma illustrant le principe de double injection selon l'invention,
- la figure 4, un second schéma illustrant les effets obtenus par l'invention,
- la figure 5, un synoptique du système de réflectométrie selon l'invention dans un premier mode de réalisation de l'invention,
- la figure 6, un diagramme représentant un exemple de réflectogramme obtenu par le système selon l'invention,
- la figure 7, un synoptique du système de réflectométrie selon l'invention dans un second mode de réalisation de l'invention.

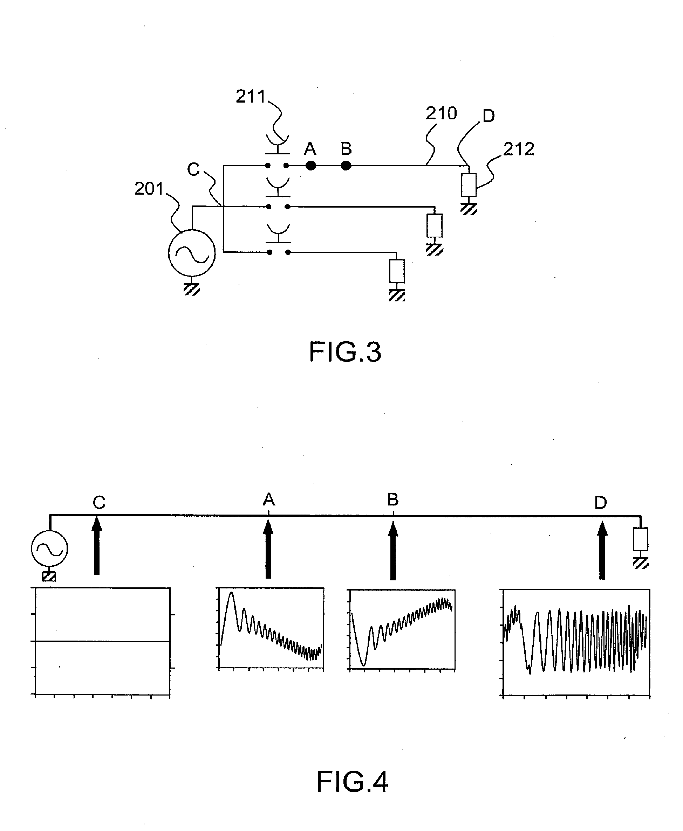

La figure 3 schématise, pour le même exemple de réseau électrique présenté aux figures 2a et 2b, le principe à la base de l'invention.

Pour pouvoir réaliser une localisation de défaut non ambigüe à partir d'un système de réflectométrie basé sur l'injection d'un signal de référence, la réflexion de ce signal sur une singularité liée au défaut et l'analyse du signal réfléchi, un objectif de l'invention est d'assurer la propagation du signal injecté dans un seul sens et non dans les deux sens comme cela serait le cas sans l'invention. Par exemple, dans le cas du réseau électrique de la figure 3, si l'on souhaite tester la ligne 210 uniquement entre le disjoncteur 211 et la charge 212, il faut que le signal injecté en un point proche du disjoncteur 211 ne se propage que vers la charge 212 et non vers le générateur 201.

Pour arriver à cet objectif, l'invention consiste notamment à injecter deux signaux en deux points A et B distincts du câble. Avantageusement, les deux points d'injection A et B sont proches. Les deux signaux $f_A(t)$ et $f_B(t)$ sont déterminés de sorte que le signal propagé dans un sens est sensiblement nul, et, dans l'autre sens, soit égal au signal de réflectométrie désiré.

Le signal $f_C(t)$ propagé vers le générateur 201, mesuré en un point C, satisfait la relation suivante, où $\Delta t_{AC}$ et $\Delta t_{AB}$ représentent respectivement les temps de propagation du signal entre le point A et le point C d'une part et entre le point A et le point B d'autre part :

$$f_C(t) = f_A(t - \Delta t_{AC}) + f_B(t - \Delta t_{AC} - \Delta t_{AB}) \qquad (1)$$

De même le signal $f_D(t)$ propagé vers la charge 212, mesuré en un point D, satisfait la relation suivante, où $\Delta t_{BD}$ représente le temps de propagation du signal entre le point B et le point D.

$$f_D(t) = f_B(t - \Delta t_{BD}) + f_A(t - \Delta t_{BD} - \Delta t_{AB}) \qquad (2)$$

En imposant au signal propagé d'un côté de la ligne, par exemple vers le point C, d'être sensiblement nul, on peut remplacer $f_C(t)$ par 0 dans la relation (1) pour obtenir la relation (3) :

$$f_A(t - \Delta t_{AC}) + f_B(t - \Delta t_{AC} - \Delta t_{AB}) = 0 \qquad (3)$$

La relation (3) est équivalente à la relation (4) après changement de variable.

$$f_A(t + \Delta t_{AB}) + f_B(t) = 0 \qquad (4)$$

De la même manière, en imposant au signal propagé vers le point D d'être sensiblement égal au signal de réflectométrie désiré s(t), on peut remplacer, dans la relation (2), le terme $f_D(t + \Delta t_{BD})$ par le terme $s(t + \Delta t_{AB})$, ce qui donne après changement de variable la relation (5) :

$$f_B(t) + f_A(t - \Delta t_{AB}) = s(t + \Delta t_{AB}) \qquad (5)$$

Les signaux $f_A(t)$ et $f_B(t)$ doivent finalement satisfaire le système d'équations suivant :

$$\begin{cases} f_A(t + \Delta t_{AB}) + f_B(t) = 0 \\ f_B(t) + f_A(t - \Delta t_{AB}) = s(t + \Delta t_{AB}) \end{cases} \qquad (6)$$

Du système (6) on en déduit la relation (7) :

$$f_A(t + \Delta t_{AB}) - f_A(t - \Delta t_{AB}) = -s(t + \Delta t_{AB}) \qquad (7)$$

La relation (7) est aussi équivalente à la relation (8) après changement de variable :

$$s(t) = -(f_A(t) - f_A(t - 2\Delta t_{AB})) \qquad (8)$$

A partir de la relation (8), on voit donc que le signal $f_A(t)$ à injecter au point A peut être déterminé en première approximation par une intégration du signal s(t) propagé vers le point D, qui n'est autre que le signal de réflectométrie qui sert à détecter une singularité sur la ligne 210.

L'intervalle d'intégration $[-\Delta t_{AB}, \Delta t_{AB}]$ est préférentiellement de durée égale à $2\Delta t_{AB}$ c'est-à-dire deux fois le temps de propagation du signal entre les points A et B.

Le signal à injecter au point B peut ensuite être déterminé à l'aide de la relation (4) : $f_B(t) = -f_A(t + \Delta t_{AB})$

Les signaux $f_A(t)$ et $f_B(t)$ injectés peuvent ainsi être déterminés directement sous forme analogique à partir des relations (8) et (4) et de la connaissance du signal de réflectométrie s(t) souhaité. Le signal $f_A(t)$ est ainsi pris égal à l'intégrale, sur un intervalle temporel de durée donnée, du signal de réflectométrie souhaité. Le signal $f_B(t)$ est égal à l'opposé du signal $f_A(t)$ et doit être injecté avec un décalage temporel par rapport à l'injection du signal $f_A(t)$ qui dépend de la distance entre les deux points d'injection A et B comme cela sera explicité par la suite dans le domaine numérique, c'est-à-dire en temps discret.

En effet, les signaux $f_A(t)$ et $f_B(t)$ injectés peuvent également être générés sous forme numérique à une fréquence d'échantillonnage $F_e = 1/T_e$. Dans ce cas, on pose en conséquence $t = nT_e$, $\Delta t_{AB} = kT_e$ et $\Delta t_{BD} = n_0 T_e$ avec $n$, $k$ et $n_0$ trois entiers positifs.

En temps discret, le système d'équations (6) s'écrit :

$$\begin{cases} f_A(n + k) + f_B(n) = 0 \\ f_B(n) + f_A(n - k) = s(n + k) \end{cases} \qquad (9)$$

Du système (9) on déduit la relation (10) :

$$-(f_A(n+k) - f_A(n-k)) = s(n+k) \qquad (10)$$

Le signal s(n) propagé vers le point D est le signal de réflectométrie qui sert à détecter une singularité sur la ligne 210. On obtient alors la relation de récurrence (11) permettant de déterminer le signal $f_A(n)$ :

$$f_A(n+k) = -s(n+k) + f_A(n-k) \qquad (11)$$

On en déduit une expression du signal $f_A(n)$ en résolvant la relation de récurrence (10) :

$$\begin{aligned} f_A(n) &= -s(n) + f_A(n-2k) \\ &= -s(n) + (-s(n-2k) + f_A(n-4k)) \\ &= -s(n) + (-s(n-2k) + (-s(n-4k) + f_A(n-6k))) \\ &= -\sum_i s(n-2ik) \end{aligned} \qquad (12)$$

La relation (12) traduit une intégration dans le domaine numérique du signal s(t) et est équivalente à la relation (13) :

$$f_A(n) = -\sum_{i=0}^{n} s(i) \qquad (13)$$

Le signal $f_A(n)$ généré pour injection au point A est ainsi déterminé à l'aide de la relation (13) et à partir du signal s(n) de réflectométrie choisi.

Le signal $f_B(n)$ généré pour injection au point B est ensuite déterminé à l'aide des relations (9) et (13) :

$$f_B(n) = -f_A(n+k) \qquad (14)$$

La valeur de k, qui correspond dans le domaine à temps continu au temps de propagation $\Delta t_{AB}$ du signal entre les points d'injection A et B, est déterminée à partir de la distance $d_{AB}$ entre les points A et B et de la connaissance, par des moyens externes à l'invention, de la vitesse de propagation Vp du signal dans le câble à tester. On a donc :

$$\Delta t_{AB} = d_{AB}/V_P \text{ et } k = \Delta t_{AB}/Te$$

Dans un mode préféré de l'invention, la valeur de k est prise égale à 1, le temps de propagation $\Delta t_{AB}$ étant ainsi pris égal à la période d'échantillonnage du signal $T_e$, ce qui signifie que les moyens d'injection des signaux A et B doivent être synchrones. Cependant, la valeur de k peut également être prise égale à un multiple ou un sous multiple de la période d'échantillonnage $T_e$, Si la fréquence d'échantillonnage est fixe, par exemple contrainte par les moyens de conversion numérique/analogique utilisés, alors la distance entre les points d'injection A et B est fixée à partir de la connaissance de la période d'échantillonnage du signal $T_e$.

Au contraire, si la fréquence d'échantillonnage peut être sélectionnée parmi plusieurs valeurs disponibles, alors l'utilisateur du système selon l'invention peut choisir la distance $d_{AB}$ la plus adaptée à l'application visée, notamment en prenant en compte les contraintes liées à l'encombrement ou aux dimensions du système de réflectométrie.

Le signal $f_A(n)$ peut donc être déterminé par simple intégration du signal s(n) de réflectométrie sur une période de temps donnée comme explicité ci-dessus pour le cas analogique. Bien que constituant une approximation du résultat obtenu par application de la relation (13), cela reste acceptable en termes de performances.

Dans un mode particulier de réalisation de l'invention, il est possible de diminuer la distance entre les points d'injection A et B à une valeur inférieure à $T_e.V_P$. En effet dans le cas où les horloges des moyens d'injections aux points A et B ne sont pas synchrones, c'est-à-dire que les périodes d'échantillonnage des signaux aux points A et B ne sont pas strictement identiques, un décalage à l'injection entre les signaux injectés aux points A et B existe déjà du fait de cet asynchronisme et peut dans ce cas être inférieur à la période d'échantillonnage $T_e$ de l'un ou l'autre des dispositifs. A partir de la connaissance du décalage temporel $\Delta_T$ lié au déphasage des horloges des moyens d'injection aux points A et B, on peut en déduire la distance $d_{AB}$ à imposer entre les points A et B par la relation $d_{AB} = \Delta_T . V_P$. Ce mode de réalisation particulier de l'invention a pour avantage de permettre de diminuer la distance entre les points d'injection A et B.

La figure 4 illustre l'effet obtenu grâce à l'invention. Les signaux générés et injectés aux points A et B permettent d'obtenir un signal propagé au point C sensiblement nul et un signal propagé au point D égal au signal de réflectométrie s(t) désiré. Grâce à l'invention, la détection d'un changement local d'impédance est possible sur la ligne entre les points B et D. Pour tester la partie de la ligne située entre les points A et C, il suffit d'inverser les signaux injectés sur les points A et B.

Le procédé selon l'invention consiste ainsi en l'exécution des étapes suivantes. Un opérateur connecte les deux entrées/sorties du système de réflectométrie selon l'invention en dérivation du câble à tester, sur deux points A et B distants d'une valeur égale à $V_P.\Delta t_{AB} = V_P.kT_e$. Un signal de réflectométrie s(t) est choisi à partir duquel les signaux à injecter $f_A(t)$ et $f_B(t)$ sont calculés. L'opérateur choisit le sens de propagation du signal voulu et les signaux $f_A(t)$ et $f_B(t)$ sont déterminés en concordance avec ce choix. Le décalage à l'injection entre les deux signaux est déterminé à partir de la connaissance de la distance entre les points A et B ou inversement cette distance est fixée à partir de la connaissance du décalage. Les signaux sont ensuite injectés dans le câble aux points A et B et le signal s(t) se propage dans le câble jusqu'à se réfléchir sur une singularité. Le signal réfléchi est reçu et enregistré par le système puis traité afin de déterminer la localisation précise de la singularité en mesurant l'écart temporel entre le signal réfléchi et le signal injecté.

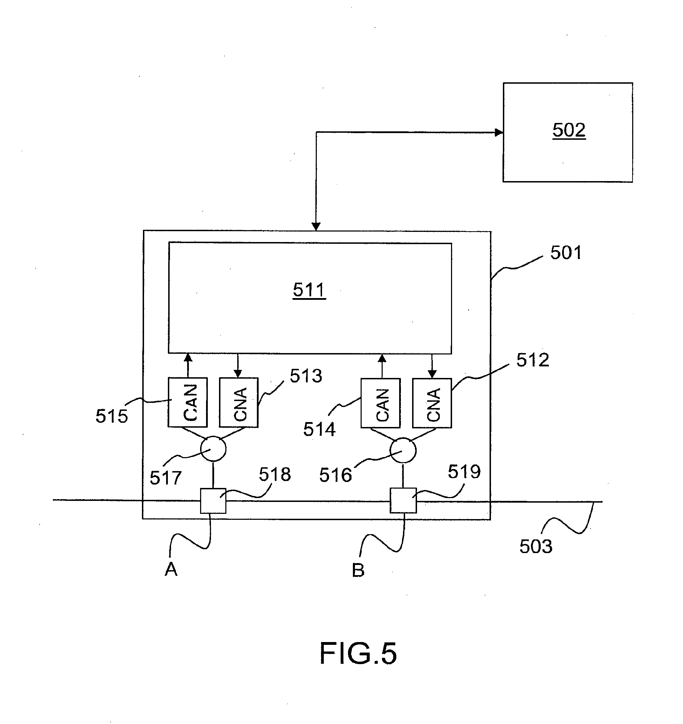

La figure 5 schématise, sur un synoptique, le système de réflectométrie dans un premier mode de réalisation de l'invention.

Un tel système 501 comporte au moins un composant électronique 511 de type circuit intégré, tel un circuit à logique programmable, par exemple de type FPGA, ou micro-contrôleur, deux convertisseurs numérique-analogique 512,513 pour injecter les signaux $f_A(t)$ et $f_B(t)$ dans le câble à tester 503, au moins un convertisseur analogique-numérique 514,515 pour recevoir le signal réfléchi sur les singularités du câble, au moins un dispositif de couplage 516,517 entre au moins un des deux convertisseurs analogique-numérique 514,515 et au moins un des deux convertisseurs numérique-analogique 512,513 et deux moyens de couplage 518,519 entre deux entrées/sorties que comportent le système et le câble à tester 503, lesdits moyens de couplage étant en outre adaptés à injecter les signaux de sortie des deux convertisseurs numérique-analogique 512,513 dans ledit câble 503 et à recevoir le ou les signaux réfléchis.

Le système 501 selon l'invention est avantageusement mis en oeuvre par une carte électronique sur laquelle sont disposés les convertisseurs numérique-analogique 512,513, le ou les convertisseurs analogique-numérique 514,515 et le ou les dispositifs de couplage 516,517. Les moyens de couplage et d'injection 518,519 sont connectés à deux entrées/sorties que comporte la carte.

En outre, une unité de traitement 502, de type ordinateur, assistant numérique personnel ou autre est utilisée pour piloter le système de réflectométrie 501 selon l'invention et afficher les résultats des mesures sur une interface homme-machine.

Le composant électronique 511 met en oeuvre d'une part les étapes de calcul nécessaires à la génération des signaux d'injection $f_A(t)$ et $f_B(t)$ à partir du signal de réflectométrie s(t) et d'autre part une analyse du signal réfléchi afin d'en déduire un réflectogramme qui est transmis à l'unité de traitement 502.

Sans sortir du cadre de l'invention, tout dispositif équivalent à un convertisseur numérique analogique permettant de passer du domaine numérique au domaine analogique est compatible de l'invention. De même tout dispositif permettant de passer du domaine analogique au domaine numérique peut remplacer le convertisseur analogique numérique.

Les signaux d'injection peuvent également être générés directement sous forme analogique comme explicité précédemment. Dans ce cas, les convertisseurs numérique-analogique 512,513 ne sont pas nécessaires et le composant électronique 511 est remplacé par un dispositif analogique tel qu'un oscilloscope analogique qui permet de générer directement les signaux d'injection $f_A(t)$ et $f_B(t)$ à partir d'un signal de réflectométrie s(t) donné. Dans un tel cas de figure, un composant supplémentaire doit être prévu pour introduire un retard configurable à l'injection du signal $f_B(t)$.

Les moyens de couplage et de transmission 518,519 peuvent être réalisés par effet capacitif, inductif, ou avec une connexion ohmique. Ils peuvent être mis en oeuvre par des moyens de connexion physique. Par exemple si le système selon l'invention est intégré avec un dispositif de protection, de type disjoncteur, déjà présent sur le réseau électrique à tester, des connecteurs physiques permettant l'injection de signaux dans le câble sont prévus. Ils peuvent également être mis en oeuvre par des moyens d'injection sans contact, par exemple en utilisant un cylindre métallique dont le diamètre interne est sensiblement égal au diamètre externe du câble et qui produit un effet de couplage capacitif avec le câble.

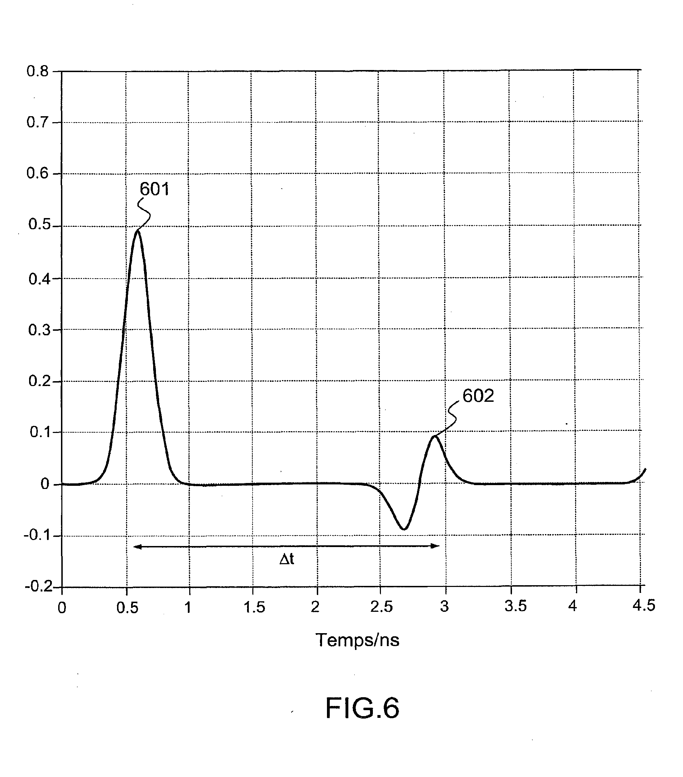

Les moyens de couplage 516,517 entre les convertisseurs 512 et 514 d'une part et 513 et 515 d'autre part peuvent être réalisés par un simple coupleur qui assure une liaison entre chaque couple de convertisseurs et chaque entrée/sortie du système. Dans ce cas, le signal de sortie des convertisseurs numérique-analogique 512,513 prêt à être injecté, via les deux sorties du système 501, dans le câble à tester, est également transmis, via les coupleurs 516,517, vers les convertisseurs analogique-numériques 514,515 chargés de recevoir le signal réfléchi sur les singularités du câble. Dans ce cas, le réflectogramme obtenu après traitement du signal reçu sur une entrée/sortie du système, comportera à la fois un pic relatif au signal injecté et un autre pic relatif au signal réfléchi. Un exemple d'un tel réflectogramme est représenté à la figure 6.

Le réflectogramme de la figure 6 comporte un premier pic 601 qui correspond au point d'injection du signal qui est ici une impulsion temporelle. Le deuxième pic 602 correspond à une singularité du câble consécutive d'un défaut électrique. La mesure du décalage temporel $\Delta t$ entre le deuxième pic 602 et le premier pic 601 permet d'en déduire la distance entre le point d'injection du signal et le défaut électrique.

Un inconvénient est que la présence du signal injecté sur le réflectogramme peut jouer négativement sur les performances de mesure de la distance entre le défaut électrique détecté sur le câble et le point d'injection pour la raison suivante. Plus le défaut électrique est éloigné du point d'injection, plus le signal réfléchi reçu par le système sera atténué et plus la précision de la mesure du retard entre signal injecté et signal réfléchi décroît. La précision est encore plus diminuée lorsque le réflectogramme comporte les deux signaux car après normalisation, l'amplitude relative du signal réfléchi par rapport à celle du signal injecté est faible.

Pour ces raisons, il peut être avantageux d'utiliser comme moyen de couplage 516,517 un diviseur-combineur qui permet d'une part de diriger le signal de sortie du convertisseur numérique-analogique 512 vers la sortie du système et d'autre part de diriger le signal réfléchi reçu sur une entrée du système vers le convertisseur analogique-numérique 514. Ainsi le réflectogramme ne comporte que l'information utile pour la localisation du défaut électrique.

Dans une variante de réalisation de l'invention, non représentée à la figure 5, un seul convertisseur analogique-numérique 514,515 est nécessaire pour acquérir le signal réfléchi. Avantageusement, le convertisseur analogique-numérique 514,515 est couplé au convertisseur numérique-analogique 512,513 relié au point d'injection le plus proche du coté du câble à tester.

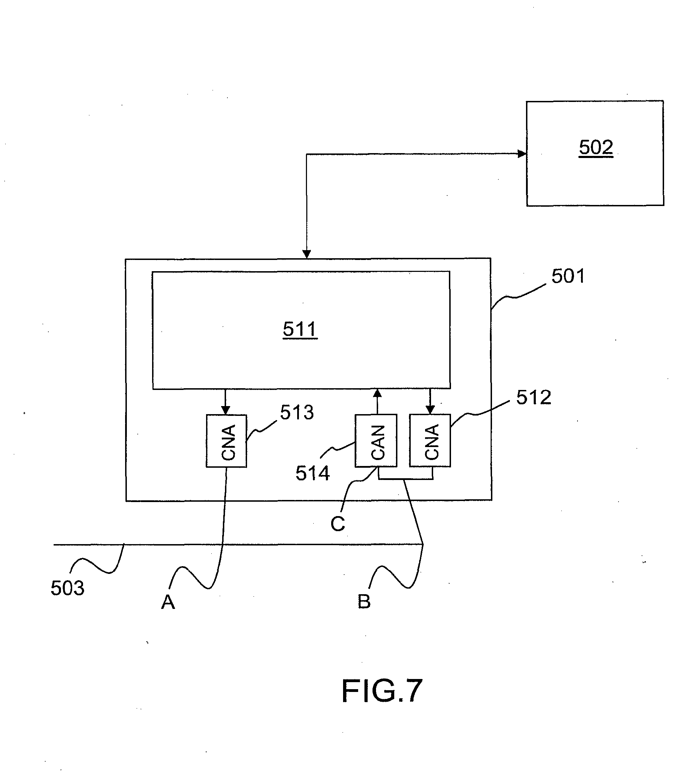

La figure 7 schématise une autre variante de mise en oeuvre du procédé et du système selon l'invention, dans laquelle seul un convertisseur analogique-numérique 514 est nécessaire.

Dans un cas où des moyens supplémentaires de couplage et d'injection 518,519 ne sont pas souhaités et qu'une extrémité B du câble à tester est accessible, l'invention permet également de supprimer l'utilisation d'un diviseur-combineur en corrigeant l'inconvénient, explicité ci-dessus, de l'utilisation d'un coupleur simple pour relier le convertisseur analogique-numérique 514 à l'un des convertisseurs numérique-analogique 512.

Pour cela, les convertisseurs 512,514 reliés entre eux à l'aide d'un coupleur simple sont connectés, via une entrée/sortie du système selon l'invention, à l'extrémité B du câble à tester. Le second convertisseur numérique-analogique 513 est relié, par connexion ohmique, à un second point A du câble distant du point B. La distance entre les deux points étant déterminée, comme déjà explicité précédemment, à partir de la connaissance de la vitesse de propagation du signal dans le câble et de la période d'échantillonnage des convertisseurs.

En considérant la ligne reliant le point C d'entrée du convertisseur analogique-numérique 514 au point A et passant par le point B et en appliquant le procédé selon l'invention, l'injection des signaux $f_A(t)$ et $f_B(t)$ aux points A et B permet d'éliminer la propagation du signal vers le point C. Ainsi, le signal réfléchi puis reçu par le système sur l'entrée C ne comporte que les informations nécessaires à la localisation du défaut électrique dans le câble 503.

L'invention a pour avantage principal de ne pas nécessiter l'introduction de composants supplémentaires sur le câble à tester. Les caractéristiques du câble ne sont ainsi pas modifiées, y compris sa bande passante, dans la mesure où l'impédance de sortie du système de diagnostic est transparente aux fréquences utilisées dans l'application visée. L'inconvénient de l'ajout de composants est qu'ils peuvent nécessiter des dimensions encombrantes, nécessaires pour garantir le respect des différentes normes utilisées, par exemple dans le domaine de réseaux électriques embarqués dans un avion.

## Revendications

1. Système de réflectométrie temporelle (501) pour la localisation, non ambigüe, d'au moins une singularité dans un câble (503), **caractérisé en ce qu'**il comprend des moyens de calcul (511) de signaux de réflectométrie adaptés à générer un premier signal d'injection $f_A(t)$ et un second signal d'injection $f_B(t)$ à partir d'au moins un signal de réflectométrie s(t), et deux moyens de couplage et de transmission (518,519) desdits signaux d'injection $f_A(t),f_B(t)$ en deux points distincts (A,B) dudit câble (503), lesdits signaux d'injection $f_A(t),f_B(t)$ étant construits de sorte que le signal se propageant d'un côté dudit câble (503) est égal audit signal de réflectométrie s(t) et le signal se propageant de l'autre côté dudit câble (503) est sensiblement nul.

2. Système de réflectométrie temporelle (501) selon la revendication 1 **caractérisé en ce que** ledit premier signal d'injection $f_A(t)$ est déterminé par intégration temporelle du signal de réflectométrie s(t).

**3.** Système de réflectométrie temporelle (501) selon la revendication 2 dans lequel ledit second signal d'injection $f_B(t)$ est égal à l'opposé dudit premier signal d'injection $f_A(t)$ et est injecté dans le câble (503) avec un retard prédéterminé, par rapport à l'instant d'injection dudit premier signal d'injection $f_A(t)$.

**4.** Système de réflectométrie temporelle (501) selon la revendication 3 dans lequel ledit retard est égal à la distance entre lesdits points d'injection (A,B) divisée par la vitesse de propagation du signal dans le câble (503).

**5.** Système de réflectométrie temporelle (501) selon l'une des revendications précédentes dans lequel lesdits signaux d'injection $f_A(t),f_B(t)$ sont générés sous forme numérique $f_A(n),f_B(n)$, ledit système (501) comportant en outre des moyens de conversion (512,513) pour convertir lesdits signaux $f_A(n),f_B(n)$ numériques en signaux analogiques $f_A(t),f_B(t)$.

**6.** Système de réflectométrie temporelle (501) selon la revendication 5 **caractérisé en ce que** lesdits signaux numériques $f_A(n),f_B(n)$ sont construits par résolution du système d'équation suivant :

$$\begin{cases} f_A(n+k) + f_B(n) = 0 \\ f_B(n) + f_A(n-k) = s(n+k) \end{cases}$$

où k est égal au rapport entre le temps de propagation $\Delta t_{AB}$ du signal entre les points A et B et la période d'échantillonnage $T_e$ desdits signaux numériques.

**7.** Système de réflectométrie temporelle (501) selon l'une des revendications 5 ou 6 **caractérisé en ce que** la distance entre les deux points d'injection (A,B) est égale à un multiple ou sous-multiple de la période d'échantillonnage $T_e$ desdits convertisseurs numérique-analogique (512,513) multiplié par la vitesse de propagation du signal dans le câble (503).

**8.** Système de réflectométrie temporelle (501) selon l'une des revendications précédentes comportant en outre au moins un convertisseur analogique-numérique (514,515) pour convertir le signal réfléchi sur ladite singularité et reçu par lesdits moyens de couplage et de transmission (518,519), lesdits moyens de calcul (511) étant en outre adaptés à recevoir et analyser ledit signal réfléchi, converti numériquement, pour produire un réflectogramme temporel.

**9.** Système de réflectométrie temporelle (501) selon l'une des revendications précédentes **caractérisé en ce que** lesdits moyens de couplage et de transmission (518,519) sont réalisés par effet capacitif, inductif ou par connexion ohmique.

**10.** Système de réflectométrie temporelle (501) selon l'une des revendications précédentes **caractérisé en ce que** lesdits moyens de couplage et de transmission (518,519) sont des moyens sans contact.

**11.** Système de réflectométrie temporelle (501) selon l'une des revendications précédentes **caractérisé en ce qu'**il comprend en outre au moins un moyen de couplage (516,517) d'un convertisseur analogique-numérique (514) avec un convertisseur numérique-analogique (512).

**12.** Système de réflectométrie temporelle (501) selon la revendication 11 **caractérisé en ce que** lesdits moyens de couplage (516,617) sont des coupleurs ou des diviseur-combineurs.

**13.** Système de réflectométrie temporelle (501) selon l'une des revendications précédentes **caractérisé en ce que** les moyens de calcul (511) sont mis en oeuvre par un circuit à logique programmable ou un micro-contrôleur.

**14.** Système de réflectométrie temporelle (501) selon l'une des revendications précédentes **caractérisé en ce qu'**il comprend en outre une unité de traitement (502) adaptée à piloter ledit système (501) et à afficher les dits réflectogrammes sur une interface homme-machine.

**15.** Procédé de localisation non ambigüe d'au moins une singularité dans un câble (503) **caractérisé en ce qu'**il comporte au moins les étapes suivantes :

- construire un premier signal d'injection $f_A(t)$ et un second signal d'injection $f_B(t)$ à partir d'un signal de réflectométrie $s(t)$ de sorte que le signal se propageant d'un côté dudit câble (503) est égal audit signal de réflectométrie $s(t)$ et le signal se propageant de l'autre côté dudit câble (503) est sensiblement nul,
- injecter lesdits signaux d'injection $f_A(t),f_B(t)$, en deux points distincts (A,B) dudit câble (503),
- acquérir le signal réfléchi sur au moins une singularité du câble,
- produire, à partir du signal réfléchi, au moins un réflectogramme temporel,
- déterminer, à partir dudit réflectogramme temporel, la position non ambigüe de la singularité sur le câble.

16. Procédé de localisation selon la revendication 15 dans lequel ledit premier signal $f_A(t)$ est déterminé par intégration temporelle du signal de réflectométrie $s(t)$.

17. Procédé de localisation selon la revendication 16 dans lequel ledit second signal d'injection $f_B(t)$ est égal à l'opposé dudit premier signal d'injection $f_A(t)$ et est injecté dans le câble (503) avec un retard prédéterminé, par rapport à l'instant d'injection dudit premier signal d'injection $f_A(t)$.

18. Procédé de localisation selon la revendication 17 dans lequel ledit retard est égal à la distance entre lesdits points d'injection (A,B) divisée par la vitesse de propagation du signal dans le câble (503).

19. Procédé de localisation selon l'une des revendications 15 à 18 **caractérisé en ce que** lesdits signaux $f_A(n),f_B(n)$ sont construits numériquement par résolution du système d'équation suivant :

$$\begin{cases} f_A(n+k) + f_B(n) = 0 \\ f_B(n) + f_A(n-k) = s(n+k) \end{cases}$$

où k est égal au rapport entre le temps de propagation $\Delta t_{AB}$ du signal entre les points A et B et la période d'échantillonnage $T_e$ desdits signaux numériques.

20. Procédé de localisation selon la revendication 19 **caractérisé en ce que** les points A et B sont séparés d'une distance égale à un multiple ou sous-multiple de la période d'échantillonnage Te des signaux numériques $f_A(n),f_B(n)$.

**Patentansprüche**

1. Zeitliches Reflektometliesystem (501) zur eindeutigen Ortung mindestens einer Unregelmäßigkeit in einem Kabel (503), **dadurch gekennzeichnet, dass** es Reflektometriesignal-Berechnungsmittel (511), die geeignet sind, um ein erstes Injektionssignal $f_A(t)$ und ein zweites Injektionssignal $f_B(t)$ aus mindestens einem Reflektometriesignal $s(t)$ zu erzeugen, und zwei Kopplungs- und Übertragungsmittel (518, 519) der Injektionssignale $f_A(t)$, $f_B(t)$ an zwei unterschiedlichen Punkten (A, B) des Kabels (503) umfasst, wobei die Injektionssignale $f_A(t)$, $f_B(t)$ derart konstruiert sind, dass das Signal, das sich von einer Seite des Kabels (503) verbreitet, gleich dem Reflektometriesignal $s(t)$ ist, und das Signal, das sich von der anderen Seite des Kabels (503) verbreitet, etwa null ist.

2. Zeitliches Reflektometriesystem (501) nach Anspruch 1, **dadurch gekennzeichnet, dass** das erste Injektionssignal $f_A(t)$ durch zeitliche Integration des Reflektometriesignals $s(t)$ bestimmt ist.

3. Zeitliches Reflektometriesystem (501) nach Anspruch 2, wobei das zweite Injektionssignal $f_B(t)$ gleich dem Gegenteil des ersten Injektionssignals $f_A(t)$ ist und in das Kabel (503) mit einer zuvor bestimmten Verzögerung im Verhältnis zum Injektionszeitpunkt des ersten Injektionssignals $f_A(t)$ eingespeist wird.

4. Zeitliches Reflektometriesystem (501) nach Anspruch 3, wobei die Verzögerung gleich dem Abstand zwischen den Injektionspunkten (A, B), dividiert durch die Verbreitungsgeschwindigkeit des Signals im Kabel (503), ist.

5. Zeitliches Reflektometriesystem (501) nach einem der vorangehenden Ansprüche, wobei die Injektionssignale $f_A(t)$, $f_B(t)$ in digitaler Form $f_A(n)$, $f_B(n)$ erzeugt werden, wobei das System (501) ferner Umwandlungsmittel (512, 513) aufweist, um die digitalen Signale $f_A(n)$, $f_B(n)$ in analoge Signale $f_A(t)$, $f_B(t)$ umzuwandeln.

6. Zeitliches Reflektometriesystem (501) nach Anspruch 5, **dadurch gekennzeichnet, dass** die digitalen Signale $f_A(n)$, $f_B(n)$ durch Lösung des folgenden Gleichungssystems konstruiert sind:

$$\begin{cases} f_A(n+k) + f_B(n) = 0 \\ f_B(n) + f_A(n-k) = s(n+k) \end{cases}$$

wobei k gleich dem Verhältnis zwischen der Verbreitungszeit $\Delta t_{AB}$ des Signals zwischen den Punkten A und B und der Samplingperiode $T_e$ der digitalen Signale ist.

7. Zeitliches Reflektometriesystem (501) nach einem der Ansprüche 5 oder 6, **dadurch gekennzeichnet, dass** der Abstand zwischen den zwei Injektionspunkten (A, B) gleich einem Vielfachen oder Unter-Vielfachen der Samplingperiode $T_e$ der Digital-Analog-Wandler (512, 513), multipliziert mit der Verbreitungsgeschwindigkeit des Signals im Kabel (503), ist.

8. Zeitliches Reflektometriesystem (501) nach einem der vorangehenden Ansprüche, das ferner mindestens einen Analog- Digital-Wandler (514, 515) aufweist, um das auf der Unregelmäßigkeit reflektierte und von den Kopplungs- und Übertragungsmitteln (518, 519) empfangene Signal umzuwandeln, wobei die Berechnungsmittel (511) ferner zum Empfangen und Analysieren des reflektierten, digital umgewandelten Signals geeignet sind, um ein zeitliches Reflektogramm zu produzieren.

9. Zeitliches Reflektometriesystem (501) nach einem der vorangehenden Ansprüche, **dadurch gekennzeichnet, dass** die Kopplungs- und Übertragungsmittel (518, 519) durch kapazitiven Effekt, induktiven Effekt oder durch ohmsche Verbindung realisiert sind.

10. Zeitliches Reflektometriesystem (501) nach einem der vorangehenden Ansprüche, **dadurch gekennzeichnet, dass** die Kopplungs- und Übertragungsmittel (518, 519) kontaktlose Mittel sind.

11. Zeitliches Reflektometriesystem (501) nach einem der vorangehenden Ansprüche, **dadurch gekennzeichnet, dass** es ferner mindestens ein Kopplungsmittel (516, 517) eines Analog-Digital-Wandlers (514) mit einem Digital-Analog-Wandler (512) umfasst.

12. Zeitliches Reflektometriesystem (501) nach Anspruch 11, **dadurch gekennzeichnet, dass** die Kopplungsmittel (516, 517) Koppler oder Teiler-Kombinierer sind.

13. Zeitliches Reflektometriesystem (501) nach einem der vorangehenden Ansprüche, **dadurch gekennzeichnet, dass** die Berechnungsmittel (511) von einem Kreis mit programmierbarer Logik oder einem Mikrocontroller umgesetzt werden.

14. Zeitliches Reflektometriesystem (501) nach einem der vorangehenden Ansprüche, **dadurch gekennzeichnet, dass** es ferner eine Verarbeitungseinheit (502) umfasst, die ausgebildet ist, um das System (501) zu steuern und um die Reflektogramme auf einer Mensch-Maschinen-Schnittstelle anzuzeigen.

15. Verfahren zur eindeutigen Ortung mindestens einer Unregelmäßigkeit in einem Kabel (503), **dadurch gekennzeichnet, dass** es mindestens die folgenden Schritte aufweist:

 - Konstruieren eines ersten Injektionssignals $f_A(t)$ und eines zweiten Injektionssignals $f_B(t)$ aus einem Reflektometriesignal s(t) derart, dass das Signal, das sich von einer Seite des Kabels (503) verbreitet, gleich dem Reflektometriesignal s(t) ist, und das Signal, das sich von der anderen Seite des Kabels (503) verbreitet, im Wesentlichen null ist,
 - Einspeisen der Injektionssignale $f_A(t)$, $f_B(t)$ an zwei unterschiedlichen Punkten (A, B) des Kabels (503),
 - Erhalten des auf mindestens einer Unregelmäßigkeit des Kabels reflektierten Signals,
 - Produzieren, aus dem reflektierten Signal, mindestens eines zeitlichen Reflektogramms,
 - Bestimmen, aus dem zeitlichen Reflektogramm, der eindeutigen Position der Unregelmäßigkeit auf dem Kabel.

16. Ortungsverfahren nach Anspruch 15, wobei das erste Signal $f_A(t)$ durch zeitliche Integration des Reflektometriesignals s(t) bestimmt wird.

**17.** Ortungsverfahren nach Anspruch 16, wobei das zweite Injektionssignal $f_B(t)$ gleich dem Gegenteil des ersten Injektionssignals $f_A(t)$ ist und in das Kabel (503) mit einer zuvor bestimmten Verzögerung im Verhältnis zum Injektionszeitpunkt des ersten Injektionssignals $f_A(t)$ eingespeist wird.

**18.** Ortungsverfahren nach Anspruch 17, wobei die Verzögerung gleich dem Abstand zwischen den Injektionspunkten (A, B), dividiert durch die Verbreitungsgeschwindigkeit des Signals im Kabel (503), ist.

**19.** Ortungsverfahren nach einem der Ansprüche 15 bis 18, **dadurch gekennzeichnet, dass** die Signale $f_A(n)$, $f_B(n)$ numerisch durch Lösung des folgenden Gleichungssystems konstruiert sind:

$$\begin{cases} f_A(n+k) + f_B(n) = 0 \\ f_B(n) + f_A(n-k) = s(n+k) \end{cases}$$

wobei k gleich dem Verhältnis zwischen der Verbreitungszeit $\Delta t_{AB}$ des Signals zwischen den Punkten A und B und der Samplingperiode $T_e$ der digitalen Signale ist.

**20.** Ortungsverfahren nach Anspruch 19, **dadurch gekennzeichnet, dass** die Punkte A und B in einem Abstand gleich einem Vielfachen oder Unter-Vielfachen der Samplingperiode $T_e$ der digitalen Signale $f_A(n)$, $f_B(n)$ getrennt sind.

**Claims**

**1.** Time domain reflectometry system (501) for localising in an unambiguous manner at least one singularity in a cable (503), **characterised in that** it comprises calculation means (511) for reflectometry signals which are generating a first injection signal $f_A(t)$ and a second injection signal $f_B(t)$ on the basis of at least one reflectometry signal s(t) and two coupling and transmission means (518, 519) for the injection signals $f_A(t)$, $f_B(t)$ at two different locations (A, B) of the cable (503), the injection signals $f_A(t)$, $f_B(t)$ being constructed in such a manner that the signal which is propagated at one side of the cable (503) is equal to the reflectometry signal s(t) and the signal which is propagated at the other side of the cable (503) is substantially zero.

**2.** Time domain reflectometry system (501) according to claim 1, **characterised in that** the first injection signal $f_A(t)$ is established by temporal integration of the reflectometry signal s(t).

**3.** Time domain reflectometry system (501) according to claim 2, wherein the second injection signal $f_B(t)$ is equal to the opposite of the first injection signal $f_A(t)$ and is injected into the cable (503) with a predetermined delay in relation to the time of injection of the first injection signal $f_A(t)$.

**4.** Time domain reflectometry system (501) according to claim 3, wherein the delay is equal to the distance between the injection locations (A, B) divided by the propagation speed of the signal in the cable (503).

**5.** Time domain reflectometry system (501) according to any one of the preceding claims, wherein the injection signals $f_A(t)$, $f_B(t)$ are generated in digital form $f_A(n)$, $f_B(n)$, the system (501) further comprising conversion means (512, 513) for converting the digital signals $f_A(n)$, $f_B(n)$ into analogue signals $f_A(t)$, $f_B(t)$.

**6.** Time domain reflectometry system (501) according to claim 5, **characterised in that** the digital signals $f_A(n)$, $f_B(n)$ are constructed by resolution of the following equation system:

$$\begin{cases} f_A(n+k) + f_B(n) = 0 \\ f_B(n) + f_A(n-k) = s(n+k) \end{cases}$$

where k is equal to the relationship between the propagation time $\Delta t_{AB}$ of the signal between the locations A and B and the sampling period $T_e$ of the digital signals.

7. Time domain reflectometry system (501) according to either claim 5 or claim 6, **characterised in that** the distance between the two injection locations (A, B) is equal to a multiple or sub-multiple of the sampling period $T_e$ of the digital/analogue converters (512, 513) multiplied by the propagation speed of the signal in the cable (503).

8. Time domain reflectometry system (501) according to any one of the preceding claims, further comprising at least one analogue/digital converter (514, 515) for converting the signal which is reflected at the singularity and which is received by the coupling and transmission means (518, 519), the calculation means (511) further being capable of receiving and analysing the reflected signal, which is digitally converted, in order to produce a temporal reflectogram.

9. Time domain reflectometry system (501) according to any one of the preceding claims, **characterised in that** the coupling and transmission means (518, 519) are constructed by a capacitive effect, an inductive effect or an ohmic connection.

10. Time domain reflectometry system (501) according to any one of the preceding claims, **characterised in that** the coupling and transmission means (518, 519) are contactless means.

11. Time domain reflectometry system (501) according to any one of the preceding claims, **characterised in that** it further comprises at least one coupling means (516, 517) for an analogue/digital converter (514) with a digital/analogue converter (512).

12. Time domain reflectometry system (501) according to claim 11, **characterised in that** the coupling means (516, 517) are couplers or dividers/combiners.

13. Time domain reflectometry system (501) according to any one of the preceding claims, **characterised in that** the calculation means (511) are implemented by a programmable logic circuit or a micro-controller.

14. Time domain reflectometry system (501) according to any one of the preceding claims, **characterised in that** it further comprises a processing unit (502) which is capable of controlling the system (501) and of displaying the reflectograms on a man/machine interface.

15. Unambiguous localisation method for at least one singularity in a cable (503), **characterised in that** it comprises at least the following steps:

 - constructing a first injection signal $f_A(t)$ and a second injection signal $f_B(t)$ on the basis of a reflectometry signal s(t) in such a manner that the signal which is propagated at one side of the cable (503) is equal to the reflectometry signal s(t) and the signal which is propagated at the other side of the cable (503) is substantially zero,
 - injecting the injection signals $f_A(t)$, $f_B(t)$ at two different locations (A, B) of the cable (503),
 - acquiring the reflected signal at least at one singularity of the cable,
 - producing, on the basis of the signal reflected, at least one temporal reflectogram,
 - establishing, on the basis of the temporal reflectogram, the unambiguous position of the singularity on the cable.

16. Localisation method according to claim 15, wherein the first signal $f_A(t)$ is established by temporal integration of the reflectometry signal s(t).

17. Localisation method according to claim 16, wherein the second injection signal $f_B(t)$ is equal to the opposite of the first injection signal $f_A(t)$ and is injected into the cable (503) with a predetermined delay in relation to the time of injection of the first injection signal $f_A(t)$.

18. Localisation method according to claim 17, wherein the delay is equal to the distance between the injection locations (A, B) divided by the propagation speed of the signal in the cable (503).

19. Localisation method according to any one of claims 15 to 18, **characterised in that** the signals $f_A(n)$, $f_B(n)$ are digitally constructed by resolution of the following equation system:

$$\begin{cases} f_A(n+k) + f_B(n) = 0 \\ f_B(n) + f_A(n-k) = s(n+k) \end{cases}$$

where k is equal to the relationship between the propagation time $\Delta t_{AB}$ of the signal between the locations A and B and the sampling period $T_e$ of the digital signals.

20. Localisation method according to claim 19, **characterised in that** the locations A and B are separated by a distance equal to a multiple or sub-multiple of the sampling period $T_e$ of the digital signals $f_A(n)$, $f_B(n)$.

FIG.1

FIG.2a

FIG.2b

FIG.3

FIG.4

FIG.5

FIG.6

502

501

511

513

CNA

512

514

CAN

CNA

C

503

A

B

FIG.7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- GB 2463689 A